**Europäisches Patentamt**

**European Patent Office**

**Office européen des brevets**

(11) Veröffentlichungsnummer: **0 172 322**
A2

## (12) EUROPÄISCHE PATENTANMELDUNG

(21) Anmeldenummer: **85106492.3**

(22) Anmeldetag: **25.05.85**

(51) Int. Cl.⁴: **G 03 F 9/00**
**G 03 F 1/04**

(30) Priorität: **18.08.84 DE 8424587 U**

(43) Veröffentlichungstag der Anmeldung:
**26.02.86 Patentblatt 86/9**

(84) Benannte Vertragsstaaten:
**BE CH DE FR GB IT LI NL SE**

(71) Anmelder: **Krause-Biagosch GmbH**
**Paul-Schwarze-Strasse 5**
**D-4800 Bielefeld 14(DE)**

(72) Erfinder: **Sielemann, Wolfram**
**Queller Strasse 1**
**D-4800 Bielefeld 14(DE)**

(74) Vertreter: **Elbertzhagen, Otto et al,**
**Patentanwälte Thielking & Elbertzhagen Gadderbaumer**
**Strasse 20**
**D-4800 Bielefeld 1(DE)**

(54) **Maskiervorrichtung.**

(57) Eine solche Maskiervorrichtung ist für ein Gerät zur Ermittlung von Ausschnitt und/oder Maßstab von durchleuchtbaren Vorlagen, wie Filmdiapositiven oder -negativen, für die Erstellung des Layouts einer Druckvorlage bestimmt. Sie besitzt mit sich zu einer Maske variabler Größe und Lage ergänzenden, einander im Eckbereich der Maske überschneidende Maskenabschnitte (4), die an gestellfesten Führungen (2) relativ zueinander verschiebbar sind und unter denen unmittelbar die durchleuchtbare Vorlage fixierbar ist.

Damit auf der Vorlage selbst oder auf deren Träger die Markierungen zur Festlegung des jeweils ausgewählten Bild- oder Vorlagenausschnittes in Abhängigkeit von den Positionen der Maskenabschnitte maschinell eingebracht werden können, sind außerhalb des Überschneidungsbereichs nahe den jeweils beiden Enden an den Maskenabschnitten (4) Markiervorrichtungen (7) angeordnet. Diese Markiervorrichtungen (7) haben einen hilfskraftbetätigten Markierdorn oder -stift (8) mit einer Markierspitze (6), die in ausgesteuerter Lage des Markierdorns (8) über die Unterseite des Maskenabschnittes (6) vorsteht.

Fig.2

EP 0 172 322 A2

- 1 -

Maskiervorrichtung

Die Erfindung bezieht sich auf eine Maskiervorrichtung für ein Gerät zur Ermittlung von Ausschnitt und/oder Maßstab von durchleuchtbaren Vorlagen, wie Filmdiapositiven oder -negativen, für die Erstellung des Layouts einer Druckvorlage mit sich zu einer Maske variabler Größe und Lage ergänzenden, einander im Eckbereich der Maske überschneidenden Maskenabschnitten, die an gestellfesten Führungen relativ zueinander verschiebbar sind und unter denen unmittelbar die durchleuchtbare Vorlage fixierbar ist.

Bei bekannten Maskiervorrichtungen dieser Art hat man bislang an der durchleuchtbaren Vorlage selbst oder an deren Träger, bei dem es sich um eine Papier- oder eine Filmfolie handeln kann, die notwendigen Markierungen des Bildausschnittes beispielsweise mittels eines Bleistiftes von Hand angebracht. Eine derartige Festlegung des Bildausschnittes ist umständlich und zeitraubend, vor allem ist sie auch ungenau

Der Erfindung liegt daher die Aufgabe zugrunde, eine Maskiervorrichtung der eingangs genannten Art zu schaffen, bei der auf der Vorlage selbst oder auf deren Träger die Markierungen zur Festlegung des jeweils ausgewählten Bild- oder Vorlagenausschnittes in Abhängigkeit von den Positionen der Maskenabschnitte maschinell eingebracht werden können.

Diese Aufgabe wird bei einer Maskiervorrichtung der gattungsgemäßen Art dadurch gelöst, daß außerhalb des Überschneidungsbereichs nahe den jeweils beiden Enden an den Maskenabschnitten Markiervorrichtungen angeordnet sind, die einen hilfskraftbetätigten Markierdorn oder -stift mit einer Markierspitze haben, wobei in ausgesteuerter Lage des Markierdorns dessen Markierspitze über die Unterseite des Maskenabschnittes vorsteht.

Der besondere Vorteil einer erfindungsgemäßen Markiervorrichtung liegt darin, daß nach jeweiliger Festlegung des Bild- oder Vorlagenausschnittes in der ausgewählten Position der Maskenabschnitte in unmittelbarer Anlage der durchleuchtbaren Vorlage oder deren Zwischenträger daran mittels der Markierspitze Markierungspunkte in die Vorlage selbst oder in deren Zwischenträger eingedrückt werden können, anhand derer dann im nachhinein mit einem Lineal oder dergleichen der ausgewählte Bildausschnitt auf dem Filmdiapositiv oder -negativ umrissen werden kann. Dabei ist es nicht erforderlich, wie vielfach üblich, die Maskenabschnitte selbst als Lineale zu verwenden, was die Auswahl des Werkstoffs für die Maskenabschnitte dadurch erleichtert, daß ein sehr dünnes Bandmaterial verwendet werden kann und damit die Abbildungsqualität der Masken in der Projektion wegen der dichten Anlage der Masken auf der Vorlage gegenüber dickerem Maskenmaterial wesentlich verbessert wird.

Die Markierspitze ist vorteilhaft so ausgebildet, daß damit bleibende Verformungen auf der Oberfläche der Vorlage oder auf deren Träger angebracht werden können. Dabei ist es von Vorteil, wenn die von der einen Seite her angebrachte Markierung auch von der gegenüberliegenden Seite der Vorlage oder des Trägers sichtbar ist. Deshalb kann die Markierung mittels einer Nadelspitze durch den Träger oder die Vorlage durchgestochen werden, ebenso gut lassen sich auch Prägungen, z.B. mit Ringschneiden oder erhitzten Markierspitzen als Markierungen anbringen.

Weitere vorteilhafte Ausgestaltungsmerkmale der Erfindung ergeben sich aus den Unteransprüchen und aus der nachstehenden Beschreibung.

Die Erfindung wird nachfolgend anhand der Zeichnung an einem Ausführungsbeispiel noch näher erläutert. Dabei zeigen:

Fig. 1 die Unteransicht der Grundplatte einer Maskiervorrichtung eines Maßstabsermittlungsgerätes zur Erstellung des Layouts einer Druckvorlage,

Fig. 2 eine perspektivische Teilansicht eines Maskenabschnittes der Vorrichtung nach Fig. 1 und

Fig. 3 einen Vertikalschnitt durch die Markiervorrichtung der Maskiervorrichtung nach den Fig. 1 und 2.

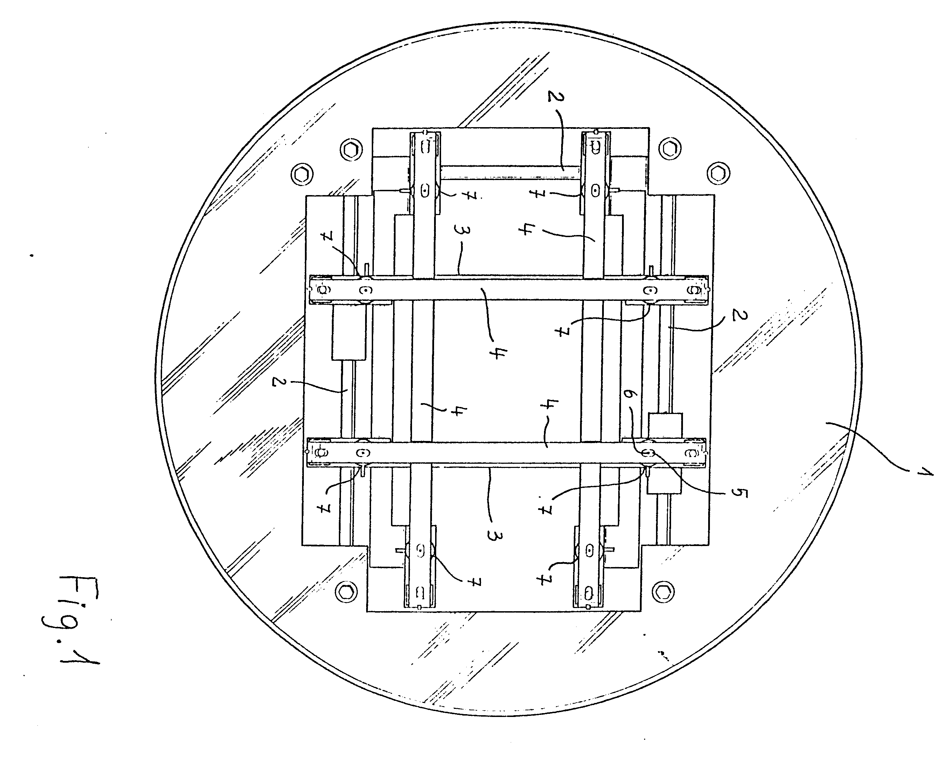

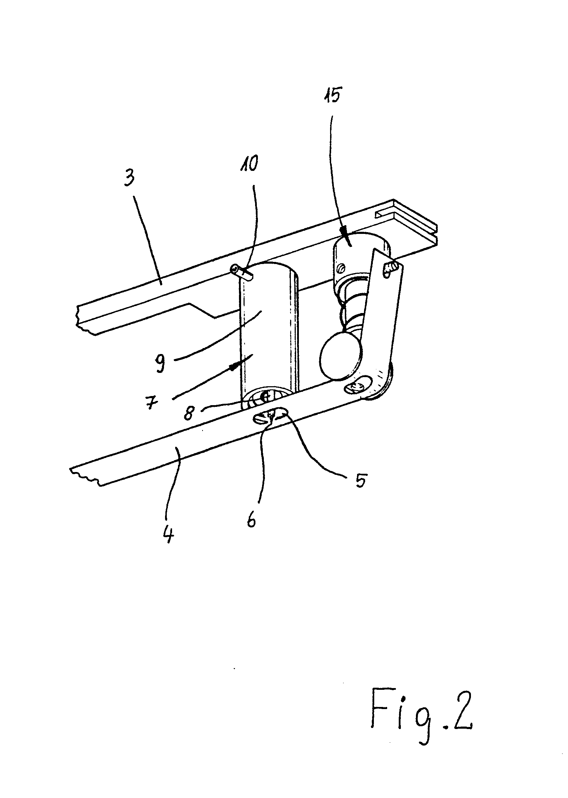

Die Darstellung von Figur 1 zeigt die Ansicht von unten gegen eine Grundplatte 1, an der eine Maskiervorrichtung für ein sogenanntes Maßstabsermittlungsgerät zur Festlegung des Layouts einer Druckvorlage angeordnet ist. Dazu sind oberseitig auf der Grundplatte 1 in rechtwinkliger Anordnung zueinander Führungen 2 befestigt, an denen im einzelnen in Fig. 2 erkennbare Streben 3 gelagert sind. Die Streben 3 tragen nach unten vorstehende Halterungen 15, zwischen denen streifenartige Maskenabschnitte 4 aufgehängt sind, die parallel in Abstand zu den Streben 3 liegen.

Wie Figur 1 weiter zeigt, ergänzen sich die Maskenabschnitte 4 zu einer quadratischen oder rechteckigen
Maske, deren Lage und Größe durch Verschiebung der
Maskenabschnitte 4 relativ zueinander variierbar ist.
Entsprechend der rechtwinkligen bzw. parallelen Lage
der Maskenabschnitte 4 zueinander sind die zugeordneten
Führungen 2 an der Oberseite der Grundplatte 1 angeordnet. Die Unterseite der Maskenabschnitte 4 liegt
in der sogenannten Grundebene, mit der auch die Unterseite der Grundplatte 1 bündig ist. Zwar kreuzen oder
überschneiden die Maskenabschnitte 4 in den Eckbereichen
der Maske einander. Dies ist jedoch vernachlässigbar.
Die in der Zeichnung nicht dargestellte durchleuchtbare
Vorlage, wie ein Filmdiapositiv oder -negativ, liegt
während des Maskiervorganges unmittelbar an der Unterseite der Grundplatte 1 und damit auch an der Unterseite
der Maskierabschnitte 4 an, wobei diese durchleuchtbare
Vorlage noch auf einem Zwischenträger angeordnet sein
kann. Sobald durch Feststellung der Maskenabschnitte 4
der geeignete Bildausschnitt der durchleuchtbaren
Vorlage ausgewählt ist, kann dieser auf dem Zwischenträger oder auf dem Filmmaterial selbst durch Markierungen festgehalten werden.

Wie die Figuren 1 und 2 veranschaulichen, besitzen die
Maskenabschnitte 4 außerhalb ihres Überschneidungsbereiches nahe ihren Enden Durchtrittsöffnungen 5,
durch die nach unten hin eine Markierspitze 6 hindurchtreten kann. Die Markierspitze 6 ist Teil eines
Markierdorns oder -stiftes 8, der wiederum hilfskraftbetätigtes Element einer Markiervorrichtung 7 ist.
Wichtig ist, daß in der ausgesteuerten unteren Endlage
die Markierspitze 6 soweit über die Unterseite des
jeweiligen Maskenabschnittes 4 hinausragt, daß in die
darunter liegende Film- oder Zwischenträgerfolie ein
Loch eingestochen oder eine Vertiefung eingeprägt werden
kann.

0172322

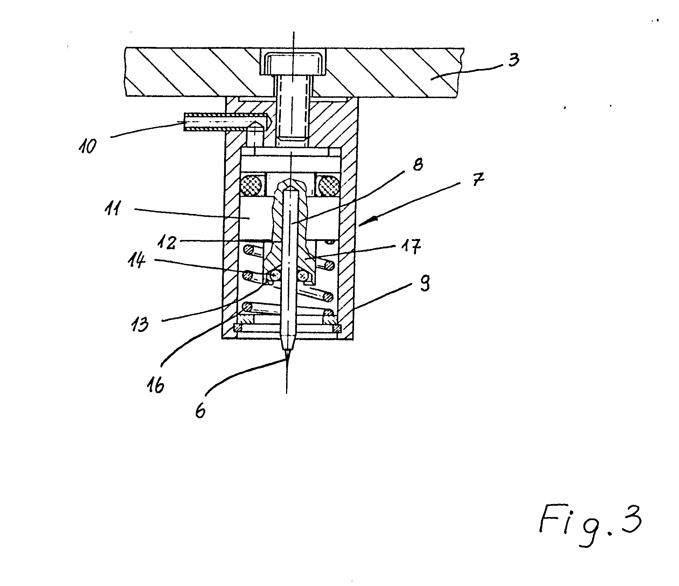

Figur 3 gibt den inneren Aufbau der Markiervorrichtung 7 wieder. Sie umfaßt einen Pneumatikzylinder 9 mit einem Anschluß 10 für einen Druckluftschlauch. In dem Zylinder 9 ist ein einfach wirkender Kolben 11 angeordnet, der in seiner oberen Ausgangslage von einer Rückstellfeder 15 festgehalten wird. Bei Druckbeaufschlagung wandert der Kolben 11 gegen die Kraft der Feder 16 nach unten und nimmt dabei den Markierdorn 8 mit. Dazu ist koaxial in den Kolben 11 bzw. in seine Kolbenstange 17 eine Aufnahme 12 für den Markierdorn 8 eingearbeitet, die nach unten hin offen ist. Nahe der unteren Öffnung erweitert sich die Aufnahme 12 zu einer Innennut 13, in die ein Rundschnurring 14, wie ein O-Ring aus Gummi, eingesetzt ist. Dieser Rundschnurring 14 dient als sicherndes Klemmelement für den Markierdorn 8, der, falls die Markierspitze 6 stumpf oder beschädigt ist, ohne Demontage der Markiervorrichtung 7 bzw. der gesamten Maskiervorrichtung ausgetauscht werden kann. Denn gegen die Reibkraft des Ringes 14 läßt sich der Dorn 8 leicht nach unten aus der Aufnahme 12 des Kolbens 11 herausziehen; andererseits ist die Klemmwirkung des Ringes 14 so ausreichend, daß der Dorn 8 nicht selbsttätig aus der Aufnahme 12 des Kolbens 11 herausfallen kann.

**0172322**

<u>Patentansprüche</u>

1. Maskiervorrichtung für ein Gerät zur Ermittlung von Ausschnitt und/oder Maßstab von durchleuchtbaren Vorlagen, wie Filmidapositiven oder -negativen, für die Erstellung des Layouts einer Druckvorlage mit sich zu einer Maske variabler Größe und Lage ergänzenden, einander im Eckbereich der Maske überschneidenden Maskenabschnitten (4), die an gestellfesten Führungen (2) relativ zueinander verschiebbar sind und unter denen unmittelbar die durchleuchtbare Vorlage fixierbar ist, dadurch gekennzeichnet, daß außerhalb des Überschneidungsbereichs nahe den jeweils beiden Enden an den Maskenabschnitten (4) Markiervorrichtungen (7) angeordnet sind, die einen hilfskraftbetätigten Markierdorn oder -stift (8) mit einer Markierspitze (6) haben, wobei in ausgesteuerter Lage des Markierdorns (8) dessen Markierspitze (6) über die Unterseite des Maskenabschnittes (4) vorsteht.

2. Maskiervorrichtung nach Anspruch 1, dadurch gekennzeichnet, daß die Markiervorrichtungen (7) oberhalb der Maskenabschnitte (4) angeordnet sind und die Maskenabschnitte (4) Durchtrittsöffnungen (5) für die Markierspitze (6) haben.

3. Maskiervorrichtung nach Anspruch 2, dadurch gekennzeichnet, daß die Maskenabschnitte (4) an in Abstand darüber liegenden, an den gestellfesten Führungen (2) gelagerten Streben (3) angeordnet sind, an den die Markiervorrichtungen (7) befestigt sind.

4. Maskiervorrichtung nach einem der Ansprüche 1 bis 3, dadurch gekennzeichnet, daß die Markiervorrichtungen (7) jeweils einen Zylinder (9) mit einem Kolben (11) umfassen, der eine zu seiner Unterseite hin offene Aufnahme (12) für den Markierdorn (8) hat.

5. Maskiervorrichtung nach Anspruch 4, dadurch gekennzeichnet, daß in der Aufnahme (12) des Kolbens (11) ein elastisches Klemmelement (14) für den Markierdorn (8) angeordnet ist.

6. Maskiervorrichtung nach Anspruch 5, dadurch gekennzeichnet, daß das Klemmelement (14) aus einem in eine Innennut (13) im unteren Bereich der Aufnahme (12) des Kolbens (11) eingesetzten Rundschnurring besteht.

Fig.1

0172322

Fig.2

Fig.3

0172322